# EUROPÄISCHE PATENTSCHRIFT

(11) **EP 0 766 354 B1**
(45) Veröffentlichungstag und Bekanntmachung des Hinweises auf die Patenterteilung: **10.04.2002**
(21) Anmeldenummer: 96114168.6
(22) Anmeldetag: 04.09.1996
(51) Int. Cl.: H01S 5/022, H01S 5/024, H01S 5/40, H01L 33/00, H01L 21/60

(54) **Laserdiodenbauelement mit Wärmesenke**
Laser diode construction element with heat sink
Elément de construction diode laser

(30) Priorität: 29.09.1995 DE 19536463
(43) Veröffentlichungstag der Anmeldung: 02.04.1997
(73) Patentinhaber: Infineon Technologies AG, 81669 München (DE)
(72) Erfinder: Späth, Werner, Dipl.-Phys., 83607 Holzkirchen (DE)
(74) Vertreter: Zedlitz, Peter, Dipl.-Inf.

(56) Entgegenhaltungen:
- US-A- 5 234 153
- PATENT ABSTRACTS OF JAPAN vol. 008, no. 053 (E-231), 9.März 1984 & JP-A-58 207689 (HITACHI SEISAKUSHO KK), 3.Dezember 1983,
- PATENT ABSTRACTS OF JAPAN vol. 017, no. 091 (E-1324), 23.Februar 1993 & JP-A-04 286177 (SUMITOMO ELECTRIC IND LTD), 12.Oktober 1992,
- PATENT ABSTRACTS OF JAPAN vol. 006, no. 155 (E-125), 17.August 1982 & JP-A-57 075485 (MITSUBISHI ELECTRIC CORP), 12.Mai 1982,
- PATENT ABSTRACTS OF JAPAN vol. 007, no. 140 (E-182), 18.Juni 1983 & JP-A-58 052892 (HITACHI SEISAKUSHO KK), 29.März 1983,
- PATENT ABSTRACTS OF JAPAN vol. 005, no. 027 (E-046), 18.Februar 1981 & JP-A-55 153389 (NEC CORP), 29.November 1980,
- APPLIED OPTICS, Bd. 27, Nr. 13, 1.Juli 1988, Seite 2632 XP000118425 HARRIS F S: "NASA PATTER"

## Beschreibung

Die Erfindung bezieht sich auf ein Laserdiodenbauelement nach dem Oberbegriff des Anspruches 1.

Die Verlustwärme von Laserdioden, insbesondere Hochleistungs-Laserdioden und -Laserdiodenbarren, muß möglichst schnell und gleichmäßig abgeführt werden. Starke Temperaturschwankungen während des Betriebes führen nämlich zu Wellenlängenverschiebungen und eine zu starke Temperaturerhöhung ist mit einer Wirkungsgradminderung verbunden, im Extremfall kann sie sogar zur Zerstörung der Laserdiode führen.

Aus der deutschen Offenlegungsschrift DE 43 15 581 ist eine Laserdiod mit Kühlsystem bekannt, bei der ein Laserdioden-Chip auf einer Grundplatte, die aus Silizium oder Kupfer besteht, befestigt ist. In die Grundplatte oder in das Substrat des Halbleiterkörpers des Laserdiodenchips sind mittels Laserstrahlbearbeitung, Stanzen, Galvanotechnik und/oder Ätzen Kanäle eingearbeitet, die nach dem Zusammenfügen der Grundplatte mit dem Halbleiterkörper ein sogenanntes Mikrokanalsystem ausbilden. Ein in dem Mikrokanalsystem fließendes Kühlmittel hat daher direkten Kontakt zum Halbleiterkörper des Laserdioden-Chips.

Die Schwierigkeit des oben beschriebenen Aufbaus aus Grundplatte und Laserdioden-Chip besteht insbesondere darin, zwischen Laserdioden-Chip und Grundplatte eine Verbindung herzustellen, die alterungsbeständige homogene elektrische und thermische Eigenschaften aufweist. Im Falle unterschiedlicher thermischer Ausdehnungskoeffizienten von Grundplattenmaterial (Si, Cu) und Halbleitermaterial (z. B. GaAs, AlGaAs und/oder AlGaAsIn), können im Betrieb an der Grenze zwischen Halbleiterkörper und Grundplatte mechanische Spannungen entstehen, die häufig zum partiellen oder vollständigen Abreißen des Halbleiterkörpers von der Grundplatte führen können. Die damit verbundene Verschlechterung der Wärmeableitung und Inhomogenität der Stromverteilung kann im Extremfall zur Zerstörung des Laserdioden-Chips führen.

Derartige Probleme beschränken sich nicht ausschließlich auf Laserdioden, sondern treten bei sämtlichen Halbleiterbauelementen auf, die im Betrieb größeren Temperaturschwankungen ausgesetzt sind.

Dem oben beschriebenen Problem wird bislang in der Halbleitertechnik im allgemeinen dadurch begegnet, daß zur Verbindung zwischen Halbleiterkörper und Kühlkörper ein elastisches oder plastisch verformbares Verbindungsmittel, wie beispielsweise Weichlot, verwendet wird. Unterschiedliche thermische Ausdehnungen von Grundplatte und Halbleiterkörper sollen hierbei durch die Verformbarkeit des Verbindungsmittels kompensiert werden. Bekannte solche Verbindungsmittel sind beispielsweise Weichlote wie Zn oder PbZn-Legierungen.

Diese Verbindungsmittel erfüllen jedoch nicht die hinsichtlich Homogenität der elektrischen und thermischen Eigenschaften und Zuverlässigkeit bei mechanischer Beanspruchung für einen stabilen Betrieb des Laserdiodenbauelements notwendigen Anforderungen.

Ein anderer Lösungsansatz zu den oben beschriebenen Problemen ist in JP 58-207 689 beschrieben. Hierin ist ein Halbleiterlaser-Bauelement vorgeschlagen, bei dem zwischen einer Kupfer- oder Eisenplatte und dem Halbleiterlaserchip ein Submount (aus Mo oder Si) angeordnet ist, das mittels Hartlot sowohl am Halbleiterlaserchip als auch an der Kupfer- oder Eisenplatte befestigt ist. In JP 55-153 389 ist ein Halbleiterlaser-Bauelement beschrieben, das den thermischen Belastungen eines Schweißprozesses standhalten soll und dazu auf dem Halbleiterchip spezielle Metallisierungsschichten aufweist.

Der Erfindung liegt die Aufgabe zugrunde, ein Laserdiodenbauelement der eingangs genannten Art zu entwickeln, bei dem die Verbindung zwischen Halbleiterkörper und Wärmesenke alterungsbeständige homogene elektrische und thermische Eigenschaften aufweist und gleichzeitig eine hohe mechanische Stabilität besitzt.

Diese Aufgabe wird durch ein Laserdiodenbauelement mit den Merkmalen des Patentanspruches 1 gelöst.

Weiterbildungen der Erfindung sind Gegenstand der Unteransprüche 2 bis 6. Bevorzugte Verfahren zum kostengünstigen Herstellen einer Mehrzahl von erfindungsgemäßen Laserdiodenbauementen sind Gegenstand der Ansprüche 7 und 8.

Erfindungsgemäß ist ein Laserdiodenbauelement vorgesehen, bei dem ein Halbleiterkörper auf einer Wärmesenke mit einem Kühlkörper befestigt ist, wobei sich die thermischen Ausdehnungskoeffizienten des Halbleiterkörpers und des Kühlkörpers stark voneinander unterscheiden (typischerweise um ca. 2*10⁻⁶ 1/K bis 3*10⁻⁶ 1/K). Zwischen dem Halbleiterkörper und dem Kühlkörper ist eine erste elektrisch und thermisch leitende Anschlußplatte angeordnet, die aus einem Material besteht, das einen ähnlichen thermischen Ausdehnungskoeffizienten aufweist wie das Halbleitermaterial des Halbleiterkörpers (typischerweise zwischen ca. 5*10⁻⁶ 1/K und ca. 6,5*10⁻⁶ 1/K).

Bei einer besonders vorteilhaften Ausführungsform des erfindungsgemäßen Laserdiodenbauelements besteht die erste Anschlußplatte aus Molybdän, Wolfram, CuW und/oder CuMo und ist diese Anschlußplatte mittels eines Hartlotes (Material siehe z. B. weiter unten) an dem Halbleiterkörper befestigt.

Bei einer bevorzugten Weiterbildung dieser Ausgestaltung ist die erste Anschlußplatte auch auf dem Kühlkörper mittels eines Hartlotes befestigt. Dies ist möglich, da die oben genannten Materialien, insbesondere Molybdän, für die Anschlußplatte einen sehr hohen Elastizitätsmodul aufweisen und von daher mechanische Spannungen weitgehend kompensieren.

Bei einer weiteren bevorzugten Weiterbildung des erfindungsgemäßen Laserdiodenbauelements ist die erste Anschlußplatte gleichzeitig als erster elektrischer Anschluß für den Halbleiterkörper und als thermischer Anschluß zum Kühlkörper genutzt. Dies ist auf einfache Weise möglich, da beispielsweise Leadframes aus Molybdän sehr einfach hergestellt werden können, auf denen dann die Halbleiterkörper befestigt werden.

Bei einer vorteilhaften Ausführungsform des erfindungsgemäßen Laserdiodenbauelements besteht der Halbleiterkörper im wesentlichen aus GaAs, AlGaAs und/oder InAlGaAs, weist der Kühlkörper eine Kühlplatte aus Diamant, aus Silizium oder aus Kupfer auf und besteht die Anschlußplatte im wesentlichen aus Molybdän, Wolfram, CuMo und/oder CuW.

Die Erfindung wird anhand zweier Ausführungsbeispiele in Verbindung mit den Figuren 1 bis 3b näher erläutert.

Es zeigen:
Figur 1 eine schematische Darstellung eines Schnittes durch das Ausführungsbeispiel,
Figuren 2a bis 2e eine schematische Darstellung eines ersten Verfahrens zum Herstellen einer Mehrzahl von erfindungsgemäßen Laserdiodenbauelementen,
Figuren 3a und 3b eine schematische Darstellung eines zweiten Verfahrens zum Herstellen einer Mehrzahl von erfindungsgemäßen Laserdiodenbauelementen.

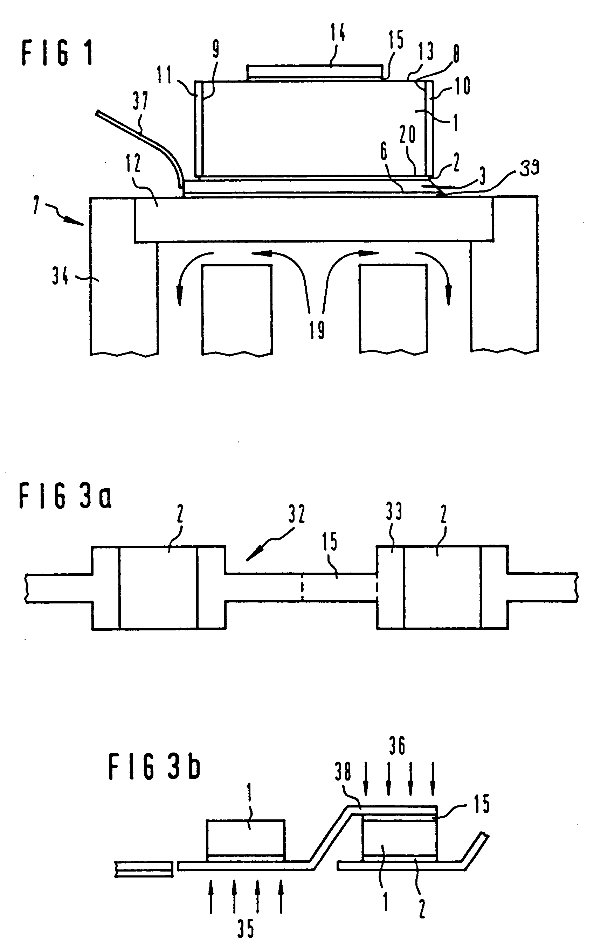

Bei dem in Figur 1 gezeigten Laserdiodenbauelement handelt es sich um eine seitlich abstrahlende Hochleistungs Laserdiode, deren Halbleiterkörper 1 beispielsweise aus GaAs, AlGaAs und/oder InAlGaAs besteht. Auf die Endflächen 8 und 9 des Halbleiterkörpers 1 ist je eine Spiegelschicht 10, 11 aufgebracht. Als Spiegelmaterial ist beispielsweise Al₂O₃, Si, SiO₂, Si₃N₄ oder SiC verwendet. Der Halbleiterkörper 1 ist mittels einer elektrisch und thermisch leitenden Verbindungsschicht 2 auf einer Anschlußplatte 3 befestigt. Die Verbindungsschicht 2 besteht aus einem Hartlot, z. B. eine AuSn-Legierung, und kann bei Bedarf beispielsweise mittels Maskentechnik oder Photolithographie strukturiert sein. Als Aufbringungsverfahren kann beispielsweise Sputtern, Aufdampfen oder Tauchen eingesetzt werden. Zur Verbesserung der Löteigenschaften der Anschlußplatte 3 und der Alterungsbeständigkeit der Lötverbindung kann auf die Anschlußplatte 3 beispielsweise eine elektrisch leitende Schicht aus einem geeigneten Hartlot Metall oder einer Hartlot Metall-Schichtenfolge (z. B. eine TiPt-, TiPd-, TiPtAu- oder eine TiPdAu-Schichtenfolge) aufgebracht sein.

An die Anschlußplatte 3, die sowohl als thermischer als auch als elektrischer Anschluß für den Halbleiterkörper 1 genutzt ist, ist ein Anschlußdraht 37 gebondet oder gelötet. Die an die Strahlaustrittsfläche 8 des Halbleiterkörpers 1 angrenzende Seitenfläche der Anschlußplatte 3, ist derart abgeschrägt, daß zum einen eine maximale Wärmeableitung gewährleistet ist, und zum anderen keine Reflexionen des Laserstrahles auf der Anschlußplatte 3 auftreten, die den Laserstrahl stören könnten. Auf der Oberseite 13 des Halbleiterkörpers 1 ist mittels einer Verbindungsschicht 15, die aus demselben Material wie die Verbindungsschicht 2 bestehen kann, eine weitere Anschlußplatte 14 befestigt, die nicht die gleiche Dicke wie die Platte 3 haben muß. Der Verbund aus dem Halbleiterkörper 1 und den Anschlußplatten 3, 14 ist mit der Unterseite 6 der Anschlußplatte 3 auf einem Kühlkörper, bestehend aus einer Kühlplatte 12 und einer Kühlmittelzuführung 34 befestigt. Alternativ kann der Kühlkörper auch ohne Kühlplatte ausgebildet sein, so daß ein Kühlmittel direkt mit der Anschlußplatte 3 in Kontakt steht.

Um die mechanischen Spannungen an den Grenzen zwischen dem Halbleiterkörper 1 und den Anschlußplatten 3, 14 aufgrund von unterschiedlichen thermischen Ausdehnungen so gering wie möglich zu halten, bestehen die Anschlußplatten 3, 14 aus einem Material, das einen ähnlichen thermischen Ausdehnungskoeffizienten aufweist, wie das Material des Halbleiterkörpers 1. Außerdem muß dieses Material gute elektrische und thermische Leitfähigkeit besitzen, da zumindest die Anschlußplatte 3 sowohl zur Stromzuführung als auch zur Wärmeableitung genutzt ist. Für einen Halbleiterkörpers 1 aus GaAs, AlGaAs und/oder InGaAsP ist beispielsweise Molybdän ein Material, das den oben genannten Anforderungen gerecht wird.

Die Dicke der Anschlußplatte 3 liegt zum Beispiel zwischen 10 und 100 µm und die Dicke der Verbindungsschicht 2 zwischen 1 und 2 µm. Dadurch ist gewähreistet, daß der Wärmewiderstand dieser beiden Komponenten gering ist, und die im Betrieb im Halbleiterkörper 1 entstehende Wärme weitgehend ungehindert an die Kühlplatte 12 abgeführt wird.

Ein Vorteil des in Figur 1 gezeigten Laserdiodenbauelements besteht u. a. darin, daß der Halbleiterkörper 1 in einfacher Weise und zuverlässig auf die Anschlußplatte 3 gelötet werden kann, da die Anschlußplatte 3 aufgrund ihrer geringen Dicke sehr exakt nach einem vorgegebenen Temperaturprogramm auf die gewünschte(n) Löttemperatur(en) aufgeheizt werden kann. Ein exakt durchführbares Temperatur-Zeit-Profil ist bekanntlich für die Herstellung von homogenen und reproduzierbaren Lötstellen von wesentlicher Bedeutung.

Zum Löten eignet sich beispielsweise bevorzugt ein Hochleistungs-Halbleiterlaser, da sich dessen Leistung einfach und genau regeln und somit die Temperatur und die Dauer des Lötvorgangs genau einstellen läßt. Der Lötvorgang kann beispielsweise durch Bestrahlen der Unterseite 6 der Anschlußplatte 3 mit Laserstrahlung erfolgen. Erforderlichenfalls kann die Anschlußplatte 3 auch vorgeheizt sein.

Die Kühlplatte 12 besteht zum Beispiel aus Diamant (Thermischer Ausdehnungskoeff. αₜₕ = 1.1*10⁻⁶ 1/K), Silizium (αₜₕ = 2.3*10⁻⁶ 1/K) und/oder Kupfer (αₜₕ = 16.6*10⁻⁶ 1/K) oder aus einem anderen gut wärmeleitenden Material. Als Verbindungsmaterial 39 zwischen Kühlplatte 12 und Anschlußplatte 3 eignet sich beispielsweise ein metallisches Weichlot wie Zn oder PbZn-Legierungen oder ein thermisch leitender elastischer Klebstoff, bei Verwendung eines Anschlußplattenmaterials mit einem hohen Elastizitätsmodul aber auch ein Hartlot, z. B. eine AuSn-Legierung. Die Kühlplatte 12 ist mit Hilfe eines Kühlmittels 19, das über eine Kühlmittelzuführung 34 an die Kühlplatte 12 herangeführt und wieder abgeführt wird, permanent gekühlt. Als Kühlmittel 19 ist beispielsweise Wasser verwendet.

Die Anschlußplatte 14 dient im Ausführungsbeispiel nach Figur 1 ausschließlich als elektrischer Anschluß für die Laserdiode. Falls erforderlich, kann aber auch auf dieser Anschlußplatte 14 eine Kühlplatte angebracht werden, um den Halbleiterkörper 1 zusätzlich zu kühlen.

Nach dem Befestigen des Halbleiterkörpers 1 auf der Anschlußplatte 3 kann das Laserdiodenbauelement in einfacher Weise, beispielsweise mittels eines thermisch leitenden Klebstoffes, auf den vorgefertigten Kühlkörper 7 beispielsweise geklebt, gelötet oder geschweißt werden. Da das Verbindungsmaterial zwischen Anschlußplatte 3 und Kühlkörper 7 keine elektrische Leitfähigkeit aufweisen muß, kann es aus einem elastischen Klebstoff bestehen, der zur Erzeugung einer thermischen Leitfähigkeit mit einem thermisch leitenden Material gefüllt ist. Mechanische Spannungen aufgrund von stark unterschiedlichen thermischen Ausdehnungskoeffizienten von Halbleitermaterial und Kühlkörpermaterial können damit weitgehend kompensiert werden.

Zur Kühlung des Halbleiterkörpers 1 kann anstelle der Kühlplatte 12 von Figur 1 beispielsweise auch ein herkömmlicher Lamellenkühler oder ein Mikrokanalkühler verwendet werden.

Die Herstellung einer thermisch und elektrisch homogenen und mechanisch stabilen Verbindung zwischen einem Halbleiterkörper 1 und einer Anschlußplatte 3, 14 ist erfahrungsgemäß dann sehr schwierig, wenn die Kontaktflächen - im Ausführungsbeispiel zwei sind dies die Oberseite 13 und die Unterseite 20 - des Halbleiterkörpers 1 mit einem Material verunreinigt sind, das das der Verbindungsschicht 2, 15 nur schlecht benetzt. Eine solche Verunreinigung tritt zum Beispiel häufig bei der Herstellung der Spiegelschichten 10, 11 des optischen Resonators einer Laserdiode auf. Diese Spiegelschichten 10, 11 werden allgemein unmittelbar nach der Herstellung des Halbleiterkörpers 7 aufgebracht. Daher ist es nur mit äußerst großem Aufwand möglich, eine Verunreinigung der Kontaktflächen des Halbleiterkörpers 1 mit Spiegelmaterial zu verhindern.

Dieses Problem kann vermittels Verwendung der oben beschriebenen Anschlußplatte(n) 3(, 14) dadurch gelöst werden, daß die Spiegelschichten 10, 11 nach dem Befestigen des Halbleiterkörpers 1 auf der (den) Anschlußplatte(n) 3(, 14) aufgebracht werden. Die Homogenität und Zuverlässigkeit der Verbindungsschichten 2,15 sowie deren Reproduzierbarkeit kann dadurch im Vergleich zu Verbindungsschichten, die nach dem bekannten Verfahrensablauf hergestellt sind, deutlich verbessert werden. Um eine Abschattung von Teilbereichen der Seitenflächen 8, 9 des Halbleiterkörpers 1 beim Spiegelbeschichten sowie eine Störung des vom Halbleiterkörper 1 ausgesandten Laserstrahles durch Reflexion auf der (den) Anschlußplatte(n) 3(, 14) zu unterbinden, darf (dürfen) die Anschlußplatte(n) 3(, 14) nicht oder nur geringfügig breiter sein als die Resonatorlänge ( = Abstand der beiden Spiegelschichten 10, 11) der Laserdiode.

Die Breite der Anschlußplatte 3 und der Anschlußplatte 14 kann beispielsweise der Resonatorlänge der Laserdiode entsprechen bzw. kleiner als die Resonatorlänge sein. Der Halbleiterkörper 1 ist dann derart auf der Anschlußplatte 3 positioniert, daß dessen Laserstrahlaustrittsfläche mit einer Seitenfläche der Anschlußplatte 3 bündig abschließt. Ebenso kann die an die Laserstrahlaustrittsfläche angrenzende Seitenfläche der Anschlußplatte 3, wie in Figur 1 gezeigt, darart abgeschrägt sein, daß die Laserstrahlung nicht gestört wird und gleichzeitig eine maximale Wärmeableitung gewährleistet ist.

Die Verwendung einer (von) erfindungsgemäßen Anschlußplatte(n) 3(, 14) ist für die soeben beschriebene Reihenfolge der Verfahrensschritte besonders vorteilhaft. Aufgrund der Anpassung der thermischen Ausdehnung der Anschlußplatten 3, 14 ist es nämlich zulässig, die Spiegelschichten 10, 11 über den Halbleiterkörper 1 hinausragen zu lassen, ohne daß deren Bruchgefahr aufgrund mechanischer Spannungen, ausgelöst durch unterschiedliche thermische Ausdehnungen, erhöht wird. Das letztgenannte Problem könnte zwar auch dadurch gelöst werden, daß die Spiegelschichten 10, 11 nur auf den Halbleiterkörper 1 aufgebracht sind. Die Anforderung, daß die Spiegelschichten 10, 11 gleichzeitig auf den Seitenfläche 8, 9 überall die gleiche Dicke aufweisen, wäre dann jedoch nur mit sehr großem prozeßtechnischen Aufwand verbunden. Eine gleichmäßige Dicke der Spiegelschichten 10, 11 ist jedoch für die Erzeugung einer möglichst störungsfreien Laserstrahlung unbedingt erforderlich.

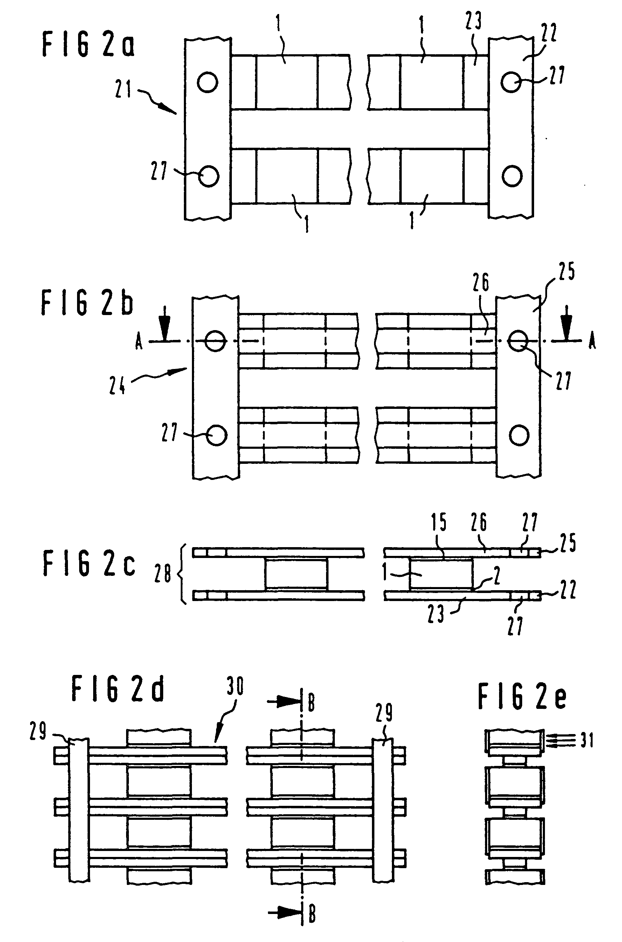

In den Figuren 2a bis 2e ist schematisch ein Verfahren dargestellt, mit dem auf einfache und rationelle Weise eine Vielzahl von Halbleiterkörpern 1 mit je einer Anschlußplatte 3, 14 auf der Unterseite 20 und der Oberseite 13 hergestellt werden kann. Bei diesem Verfahren wird zunächst eine Mehrzahl von Halbleiterkörpern 1 auf einem Leiterband 21, auf dem das Material der Verbindungsschicht 2 bereits aufgebracht ist, befestigt. Das Leiterband 21 besteht aus dem Material der Anschlußplatte 3 und weist zwei randseitige perforierte Führungs- und Transportstreifen 22 auf, die über voneinander getrennte Stege 23 miteinander verbunden sind. Nach der Montage der Halbleiterkörper 1 auf das Leiterband 21 wird auf den Oberseiten 13 der Halbeiterkörper 1 ein zweites Leiterband 24 befestigt, das, wie das Leiterband 21, zwei randseitige perforierte Führungs- und Transportstreifen 25 aufweist, die über voneinander getrennte Stege 26 miteinander verbunden sind. Auch hier ist das Material der Verbindungsschicht 15 bereits auf das Leiterband 24 oder auf dem Halbleiterkörper 1 aufgebracht. Das Leiterband 24 besteht vorzugsweise aus demselben Material wie das Leiterband 21. Die Stege 26 des Leiterbandes 24 sind schmäler als die Stege 23 des Leiterbandes 21, was jedoch nicht als Einschränkung auf diesen Fall zu betrachten ist. Ebenso könnten die Stege 23 und 26 eine gleiche Breite aufweisen, oder die Stege 26 breiter als die Stege 23 sein.

Als Lötverfahren zum festen Verbinden der Leiterbänder 21 und 24 kann das weiter oben beschriebene Laserlöten oder auch jedes andere geeignete Lötverfahren eingesetzt werden.

Nachfolgend wird der oben beschriebene sandwichartig aufgebaute Verbund aus den beiden Leiterbändern 21, 24 und den Halbleiterkörpern 1 zwischen den Stegen 23, 26 in Einzelstreifen 28 aufgetrennt. Die Figur 2c zeigt einen Schnitt durch einen solchen Einzelstreifen 28 entlang der in Figur 2b eingezeichneten Linie A-A. Zur Weiterverarbeitung, beispielsweise zur Spiegelbeschichtung, kann nachfolgend, wie in Figur 2d gezeigt, eine Mehrzahl solcher Einzelstreifen 28 auf Führungsschienen 29, die beispielsweise durch die Perforationslöcher 27 verlaufen, aufgeschoben und übereinandergestapelt werden. Ein Schnitt durch einen solchen Stapelverbund 30 entlang der in Figur 2d eingezeichneten Linie B-B ist in Figur 2e gezeigt. Hierin ist durch die Pfeile 31 das Beschichten der Seitenflächen der Halbleiterkörper 1 mit Spiegelmaterial, beispielsweise mittels Aufdampfen, angedeutet. Nach Fertigstellung der Verbunde aus Halbleiterkörper 1 und Anschlußplatten 3, 14 wird der Stapelverbund 30 in die gewünschten Einheiten, in Einzelchips oder in Arrays aus mehreren Laserdioden, vereinzelt.

Die in den Figuren 3a und 3b dargestellte zweite Verfahrensvariante zum rationellen Verbinden einer Mehrzahl von Halbleiterkörpern 1 mit Anschlußplatten 3, 14 eignet sich insbesondere zum Herstellen von Serienschaltungen aus mehreren Laserdiodenbauelementen. Bei diesem Verfahren wird ein Leiterband 32 verwendet, das in bestimmten Abständen Verbreiterungen 33 aufweist. Das Leiterband 32 ist auf der Ober- und Unterseite in den Kontaktbereichen mit Verbindungsschichten 2 bzw. 15 versehen und besteht wiederum aus einem Material mit einem ähnlichen thermischen Ausdehnungskoeffizienten wie das Halbleitermaterial der Halbleiterkörper 1. Als Material für die Verbindungsschichten 2, 15 eignet sich ein Hartlot, beispielsweise eine AuSn-Legierung. Die Verbindungschichten 2, 15 können vor der Montage ebenso auf den Halbleiterköpern 1 aufgebracht werden.

Der Montageablauf der in den Figuren 3a und 3b schematisch dargestellten Verfahrensvariante zur Herstellung einer Mehrzahl von Einzelbauelementen oder einer Mehrzahl von Serienschaltungen aus mehreren Laserdiodenbauelementen, weist folgende aufeinanderfolgende Verfahrensschritt auf:
1. Befestigen eines Halbleiterkörpers 32 auf einer Verbreiterung 30 des Leiterbandes 29, beispielsweise mittels Laserlöten durch Laserbestrahlung 35 der Unterseite des Leiterbandes 32;
2. Durchschneiden des Leiterbandes 32 im schmalen Bereich des Leiterbandes 32;
3. Biegen des Leiterbandes 32 derart, daß zumindest ein Teil der Unterseite des schmalen Bereiches des Leiterbandes 32 in Höhe der Oberseite des Halbleiterkörpers 1 zu liegen kommt;
4. Schmalen Bereich des Leiterbandes 32 über den benachbarten Halbleiterkörper 1 schieben;
5. Befestigen des schmalen Bereiches des Leiterbandes 32 auf dem Halbleiterkörper 1, beispielsweise mittels Laserbestrahlung 36;
6. Wiederholen des Vorganges, beginnend bei Schritt 1.

Falls erforderlich, können auch bei diesem Verfahren nach der Leiterbandmontage Deckschichten, wie beispielsweise Spiegelschichten für den optischen Resonator einer Laserdiode, auf den Halbleiterkörper 1 aufgebracht werden.

Denkbar ist bei dem in den Figuren 2a und b dargstellten Verfahren auch die Verwendung eines Leiterbandes mit durchwegs gleicher Breite, wenn dies von Vorteil oder notwendig ist.

Das Leiterband 32 kann in bestimmten Abständen mit Löchern versehen sein, so daß gegebenenfalls Leiterbandabschnitte mit Halbleiterkörpern 1 ähnlich der Figur 2d auf Führungsschienen aufgeschoben und übereinandergestapelt werden können.

Die oben beschriebenen Bauarten von Laserdiodenbauelementen und Verfahren zu deren Herstellung sind nicht nur auf einzelne Laserdiodenbauelemente, wie Einzellaserdioden und Einzeltransistoren beschränkt, sondern können ebenso beispielsweise bei Laserdiodenbarren und integrierten Schaltkreisen verwendet werden.

## Patentansprüche

1. Laserdiodenbauelement, bei dem ein Halbleiterkörper (1) auf einer Wärmesenke mit einem Kühlkörper (12) befestigt ist, zwischen dem Halbleiterkörper (1) und dem Kühlkörper (12) eine erste elektrisch und thermisch leitende Anschlußplatte (3) angeordnet ist, die aus einem Material besteht, das einen ähnlichen thermischen Ausdehnungskoeffizienten aufweist, wie das Halbleitermaterial des Halbleiterkörpers (1), und bei dem der Halbleiterkörper (1) mittels eines Hartlotes auf der ersten Anschlußplatte (3) befestigt ist, **dadurch gekennzeichnet, daß** die erste Anschlußplatte (3) gleichzeitig als erster elektrischer Anschluß für den Halbleiterkörper (1) und als thermischer Anschluß zum Kühlkörper (12) genutzt ist, daß an dem Halbleiterkörper (1) eine zweite Anschlußplatte (14) befestigt ist, die als zweiter elektrischer Anschluß des Halbleiterkörpers (1) genutzt ist und daß das Material der zweiten Anschlußplatte (14) einen ähnlichen thermischen Ausdehnungskoeffizienten aufweist wie das Material der ersten Anschlußpiatte (3).

2. Laserdiodenbauelement nach Anspruch 1,
**dadurch gekennzeichnet, daß** die zweite Anschlußplatte (14) ebenfalls mittels eines Hartlotes mit dem Halbleiterkörper (1) verbunden ist.

3. Laserdiodenbauelement nach Anspruch 1 oder 2,
**dadurch gekennzeichnet, daß** der Kühlkörper (12) an der ersten Anschlußplatte (3) befestigt ist.

4. Laserdiodenbauelement nach einem der Ansprüche 1 bis 3,
**dadurch gekennzeichnet, daß** die beiden Anschlußplatten (3, 14) auf gegenüberliegenden Seiten des Halbleiterkörpers (1) angeordnet sind.

5. Laserdiodenbauelement nach einem der Ansprüche 1 bis 4,
**dadurch gekennzeichnet, daß** der Halbleiterkörper (1) im wesentlichen GaAs, AlGaAs und/oder InAlGaAs aufweist, daß der Kühlkörper (12) Diamant, Silizium oder Kupfer aufweist und daß die Anschlußplatte (3) Molybdän oder Wolfram aufweist.

6. Laserdodenbauelement nach einem der Ansprüche 1 bis 5, **dadurch gekennzeichnet, daß** die Anschlußplatte (3) mittels eines Hartlotes an dem Halbleiterkörper (1) befestigt ist, die eine Schichtenfolge aus Ti-Pt-AuSn aufweist.

7. Verfahren zum Herstellen einer Mehrzahl von Laserdiodenbauelementen nach einem der Ansprüche 1 bis 6, **gekennzeichnet durch** die Verfahrensschritte:
a) Befestigen einer Mehrzahl von Halbleiterkörpern (1) auf einem ersten Leiterband (21), das aus dem Material der Anschlußplatte (3) besteht,
b) Befestigen eines aus dem Material der zweiten Anschlußplatte (14) bestehenden zweiten Leiterbandes (24) auf der Mehrzahl von Halbleiterkörpern (1),
c) Zertrennen des Verbundes aus den beiden Leiterbändern (21, 24) und der Mehrzahl von Halbleiterkörpern (1) in einzelne Laserdioden oder in Laserdioden-Arrays und
d) Aufbringen von Spiegelschichten (10,11) auf zwei gegenüberliegenden Seitenflächen (8,9) der Halbleiterkörper (1).

8. Verfahren zum Herstellen einer Mehrzahl von Laserdiodenbauelementen nach einem der Ansprüch 1 bis 6, **gekennzeichnet durch** die sich wiederholdenden Verfahrensschritte:
a) Befestigen eines ersten Halbleiterkörpers (1) auf einem Leiterband (32), das aus dem Material der Anschlußplatte (3) besteht,
b) Durchtrennen des Leiterbandes (32) neben dem ersten Halbleiterkörper (1),
c) Verformen des vom ersten Halbleiterkörper (1) abgetrennten Teiles des Leiterbandes (32) derart, daß eine Unterseite eines Teilbereiches (38) des abgetrennten Teiles des Leiterbandes in Höhe der Oberseite (13) des ersten Halbleiterkörpers (1) zu liegen kommt,
d) Befestigen des Teilbereiches (38) des Leiterbandes (32) auf der Oberseite (13) des ersten Halbleiterkörpers (1),
e) Befestigen eines zweiten Halbleiterkörpers (1) auf dem vom ersten Halbleiterkörper (1) abgetrennten Teil des Leiterbandes (32),
f) Zertrennen des Leiterbandes (32) zwischen dem ersten und dem zweiten Halbleiterkörper (1) oder bei einer Herstellung von Laserdioden-Arrays zwischen einzelnen Gruppen, bestehend aus mehreren seriell verschalteten Halbleiterkörpern (1).

## Claims

1. Laser diode component, in which a semiconductor body (1) is fixed on a heat sink with a cooling body (12), a first electrically and thermally conductive connection plate (3) is arranged between the semiconductor body (1) and the cooling body (12), which connection plate is composed of a material having a similar thermal expansion coefficient to the semiconductor material of the semiconductor body (1), and in which the semiconductor body (1) is fixed on the first connection plate (3) by means of a hard solder, **characterized in that** the first connection plate (3) is simultaneously utilized as first electrical connection for the semiconductor body (1) and as thermal connection to the cooling body (12), **in that** a second connection plate (14) is fixed to the semiconductor body (1), which connection plate is utilized as second electrical connection of the semiconductor body (1), and **in that** the material of the second connection plate (14) has a similar thermal expansion coefficient to the material of the first connection plate (3).

2. Laser diode component according to Claim 1,
**characterized in that** the second connection plate (14) is likewise connected to the semiconductor body (1) by means of a hard solder.

3. Laser diode component according to Claim 1 or 2,
**characterized in that** the cooling body (12) is fixed to the first connection plate (3).

4. Laser diode component according to one of Claims 1 to 3,
**characterized in that** the two connection plates (3, 14) are arranged on opposite sides of the semiconductor body (1).

5. Laser diode component according to one of Claims 1 to 4,
**characterized in that** the semiconductor body (1) essentially has GaAs, AlGaAs and/or InAlGaAs, **in that** the cooling body (12) has diamond, silicon or copper, and **in that** the connection plate (3) has molybdenum or tungsten.

6. Laser diode component according to one of Claims 1 to 5,
**characterized in that** the connection plate (3) is fixed to the semiconductor body (1) by means of a hard solder which has a layer sequence comprising Ti-Pt-AuSn.

7. Method for producing a plurality of laser diode components according to one of Claims 1 to 6,
**characterized by** the method steps of:
a) fixing a plurality of semiconductor bodies (1) on a first conductor strip (21), which is composed of the material of the connection plate (3),
b) fixing a second conductor strip (24), composed of the material of the second connection plate (14), on the plurality of semiconductor bodies (1),
c) separating the composite comprising the two conductor strips (21, 24) and the plurality of semiconductor bodies (1) into individual laser diodes or into laser diode arrays, and
d) applying mirror layers (10, 11) on two opposite side faces (8, 9) of the semiconductor bodies (1).

8. Method for producing a plurality of laser diode components according to one of Claims 1 to 6,
**characterized by** the repeated method steps of:
a) fixing a first semiconductor body (1) on a conductor strip (32), which is composed of the material of the connection plate (3),
b) severing the conductor strip (32) beside the first semiconductor body (1),
c) deforming that part of the conductor strip (32) which is separated from the first semiconductor body (1) in such a way that an underside of a partial region (38) of the separated part of the conductor strip ends up at the level of the top side (13) of the first semiconductor body (1),
d) fixing the partial region (38) of the conductor strip (32) on the top side (13) of the first semiconductor body (1),
e) fixing a second semiconductor body (1) on that part of the conductor strip (32) which is separated from the first semiconductor body (1),
f) separating the conductor strip (32) between the first and the second semiconductor body (1) or, in the case of producing laser diode arrays, between individual groups, comprising a plurality of semiconductor bodies (1) connected up in series.

## Revendications

1. Composant de diode laser, dans lequel un corps (1) semiconducteur est fixé sur un puits de chaleur par un radiateur (12), il est monté entre le corps (1) semiconducteur et le radiateur (12), une première plaque (3) de raccordement conductrice de l'électricité et de la chaleur, en un matériau qui a un coefficient de dilatation thermique analogue à celui du matériau semiconducteur du corps (1) semiconducteur, et dans lequel le corps (1) semiconducteur est fixé au moyen d'une brasure dure, sur la première plaque (3) de raccordement, **caractérisé en ce que** la première plaque (3) de raccordement est utilisé en même temps comme première borne électrique pour le corps (1) semiconducteur et comme borne thermique pour le radiateur (12), **en ce qu'**il est fixé sur le corps (1) semiconducteur une deuxième plaque (14) de raccordement, qui est utilisée comme deuxième borne électrique du corps (1) semiconducteur, et **en ce que** le matériau de la deuxième plaque (14) de raccordement a un coefficient de dilatation thermique analogue au matériau de la première plaque (3) de raccordement.

2. Composant de diode laser suivant la revendication 1, **caractérisé en ce que** la deuxième plaque (14) de raccordement, est reliée également au moyen d'une brasure dure au corps (1) semiconducteur.

3. Composant de diode laser suivant la revendication 1 ou 2, **caractérisé en ce que** le radiateur (12) est fixé à la première plaque (3) de raccordement.

4. Composant de diode laser suivant l'une des revendications 1 à 3, **caractérisé en ce que** les deux plaques (3, 14) de raccordement sont disposées sur des faces opposées du corps (1) semiconducteur.

5. Composant de diode laser suivant l'une des revendications 1 à 4, **caractérisé en ce que** le corps (1) semiconducteur, comporte essentiellement du GaAs, de l'AlGaAs et/ou de l'InAlGaAs, **en ce que** le radiateur (12) comporte du diamant, du silicium ou du cuivre et **en ce que** la plaque (3) de raccordement comporte du molybdène ou du tungstène.

6. Composant de diode laser suivant l'une des revendications 1 à 5, **caractérisé en ce que** la plaque (3) de raccordement est fixée au moyen d'une brasure dure, au corps (1) semiconducteur qui comporte une succession de couches en Ti-Pt-AuSn.

7. Procédé de fabrication d'une multiplicité de composants de diode laser suivant l'une des revendications 1 à 6, **caractérisé par** les stades de procédé :
a) fixation d'une multiplicité de corps (1) semiconducteurs sur une première bande (21) conductrice, en le matériau de la plaque (3) de raccordement,
b) fixation d'une deuxième bande (24) semiconductrice, en le matériau de la deuxième plaque (14) de raccordement, sur la multiplicité de corps (1) semiconducteurs,
c) séparation du composite constitué des deux bandes (21, 24) conductrices et de la multiplicité de corps (1) semiconducteurs, en diodes lasers individuelles ou en réseaux de diodes lasers et
d) dépôt de couches (10, 11) de miroir, sur deux surfaces (8, 9) latérales opposées, des corps (1) semiconducteurs.

8. Procédé de fabrication d'une multiplicité de composants de diodes lasers suivant l'une des revendications 1 à 6, **caractérisé par** les stades de procédés qui se répètent :
a) fixation d'un premier corps (1) semiconducteur sur une bande (32) conductrice, en le matériau de la plaque (3) de raccordement,
b) séparation de la bande (32) conductrice à côté du premier corps (1) semiconducteur,
c) déformation de la partie de la bande (32) semiconductrice séparée du premier corps (1) semiconducteur, de façon qu'une face inférieure d'une sous-partie (38) de la partie de la bande conductrice séparée vienne au niveau de la face (13) supérieure du premier corps (1) semiconducteur,
d) fixation de la sous-partie (38) de la bande (32) conductrice sur la face (13) supérieure du premier corps (1) semiconducteur,
e) fixation d'un deuxième corps (1) semiconducteur sur la partie de la bande (32) conductrice, qui est séparée du premier corps (1) semiconducteur,
f) séparation de la bande (32) conductrice, entre le premier et le deuxième corps (1) semiconducteurs ou, si l'on fabrique des réseaux de diodes lasers, entre des groupes individuels constitués de plusieurs corps (1) semiconducteurs montés en série.
